# EUROPÄISCHE PATENTANMELDUNG

(11) **EP 3 318 787 A1**
(43) Veröffentlichungstag der Anmeldung: **09.05.2018**
(21) Anmeldenummer: 16196985.2
(22) Anmeldetag: 03.11.2016
(51) Int. Cl.: F16K 51/02

(54) **VAKUUMVENTILSYSTEM ZUM GEREGELTEN BETRIEB EINES VAKUUMPROZESSES**

(71) Anmelder: VAT Holding AG, 9469 Haag (CH)
(72) Erfinder: Böhm, Christoph, CH-9473 Gams (CH); Seitz, Daniel, CH-9434 Au (CH)
(74) Vertreter: Kaminski Harmann

(57) **Zusammenfassung**

Ventilsystem aus einem Vakuumventil und einer Regeleinheit, wobei das Vakuumventil einen Ventilsitz aufweist, der eine Ventilöffnung und eine die Ventilöffnung umlaufende erste Dichtfläche aufweist, und über einen Ventilverschluss zum im Wesentlichen gasdichten Verschliessen der Ventilöffnung mit einer zweiten zu der ersten Dichtfläche korrespondierenden Dichtfläche verfügt. Eine mit dem Ventilverschluss gekoppelte Antriebseinheit ist derart ausgebildet, dass der Ventilverschluss zur Bereitstellung von jeweiligen Ventilöffnungszuständen, die von jeweiligen Zuständen des Ventilverschlusses abhängen, definiert variierbar und einstellbar ist. Die Regeleinheit ist ausgebildet zur Ausführung eines eine gezielte Variation bzw. Einstellung des Ventilöffnungszustands bereitstellenden Regelprozesses durch Ansteuerung der Antriebseinheit basierend auf einer aktuell bestimmten Regelgrösse für einen Prozessparameter und einer Zielgrösse. Die Regeleinheit weist eine Überprüfungsfunktionalität zur Überwachung des Regelprozesses auf, die derart konfiguriert ist, dass bei Ausführung der Überprüfungsfunktionalität im Rahmen der Ausführung des Regelprozesses eine Serie von Zuständen des Ventilverschlusses über zumindest einen Zeitabschnitt des Regelprozesses erfasst wird und diese als aktuelle Regeldaten (21a) gespeichert werden, die aktuellen Regeldaten (21a) mit bestimmten Sollregeldaten (20,20a) verglichen werden und basierend auf dem Vergleich der aktuellen Regeldaten (21a) mit den Sollregeldaten (20,20a) eine Prozessinformation erzeugt wird.

## Beschreibung

Die Erfindung betrifft ein System aus einem Vakuumregelventil und einer Regeleinheit für den geregelten Betrieb eines Bearbeitungsprozesses unter Vakuumbedingungen.

Allgemein sind Vakuumventile zur Regelung eines Volumen- oder Massenstroms und zum im Wesentlichen gasdichten Schliessen eines Fliesswegs, der durch eine in einem Ventilgehäuse ausgeformte Öffnung führt, in unterschiedlichen Ausführungsformen aus dem Stand der Technik bekannt und kommen insbesondere bei Vakuumkammersystemen im Bereich der IC-, Halbleiter- oder Substratfertigung, die in einer geschützten Atmosphäre möglichst ohne das Vorhandensein verunreinigender Partikel stattfinden muss, zum Einsatz. Derartige Vakuumkammersysteme umfassen insbesondere mindestens eine zur Aufnahme von zu bearbeitenden oder herzustellenden Halbleiterelementen oder Substraten vorgesehene, evakuierbare Vakuumkammer, die mindestens eine Vakuumkammeröffnung besitzt, durch welche die Halbleiterelemente oder anderen Substrate in die und aus der Vakuumkammer führbar sind, sowie mindestens eine Vakuumpumpe zum Evakuieren der Vakuumkammer. Beispielsweise durchlaufen in einer Fertigungsanlage für Halbleiter-Wafer oder Flüssigkristall-Substrate die hochsensiblen Halbleiter- oder Flüssigkristall-Elemente sequentiell mehrere Prozess-Vakuumkammern, in denen die innerhalb der Prozess-Vakuumkammern befindlichen Teile mittels jeweils einer Bearbeitungsvorrichtung bearbeitet werden. Sowohl während des Bearbeitungsprozesses innerhalb der Prozess-Vakuumkammern, als auch während des Transports von Kammer zu Kammer müssen sich die hochsensiblen Halbleiterelemente oder Substrate stets in geschützter Atmosphäre - insbesondere in luftleerer Umgebung - befinden.

Hierfür kommen zum einen Peripherieventile zum Öffnen und Schliessen einer Gaszu- oder -abfuhr und zum anderen Transferventile zum Öffnen und Schliessen der Transferöffnungen der Vakuumkammern für das Ein- und Ausführen der Teile zum Einsatz.

Die von Halbleiterteilen durchlaufenen Vakuumventile werden aufgrund des beschriebenen Anwendungsgebiets und der damit verbundenen Dimensionierung als Vakuum-Transferventile, aufgrund ihres mehrheitlich rechteckigen Öffnungsquerschnitts auch als Rechteckventil und aufgrund ihrer üblichen Funktionsweise auch als Schieberventil, Rechteckschieber oder Transferschieberventil bezeichnet.

Peripherieventile werden insbesondere zur Steuerung oder Regelung des Gasflusses zwischen einer Vakuumkammer und einer Vakuumpumpe oder einer weiteren Vakuumkammer eingesetzt. Peripherieventile befinden sich beispielsweise innerhalb eines Rohrsystems zwischen einer Prozess-Vakuumkammer oder einer Transferkammer und einer Vakuumpumpe, der Atmosphäre oder einer weiteren Prozess-Vakuumkammer. Der Öffnungsquerschnitt derartiger Ventile, auch Pumpenventile genannt, ist in der Regel kleiner als bei einem Vakuum-Transferventil. Da Peripherieventile abhängig vom Einsatzgebiet nicht nur zum vollständigen Öffnen und Schliessen einer Öffnung, sondern auch zum Steuern oder Regeln eines Durchflusses durch kontinuierliches Verstellen des Öffnungsquerschnitts zwischen eine vollständigen Offenstellung und einer gasdichten Geschlossenstellung eingesetzt werden, werden sie auch als Regelventile bezeichnet. Ein mögliches Peripherieventil zur Steuerung oder Regelung des Gasflusses ist das Pendelventil.

Bei einem typischen Pendelventil, wie beispielsweise aus der US 6,089,537 (Olmsted) bekannt, wird in einem ersten Schritt ein in der Regel runder Ventilteller über eine in der Regel ebenfalls runde Öffnung von einer die Öffnung freigebenden Stellung in eine die Öffnung überdeckende Zwischenstellung rotatorisch geschwenkt. Im Falle eines Schieberventils, wie beispielsweise in der US 6,416,037 (Geiser) oder der US 6,056,266 (Blecha) beschrieben, ist der Ventilteller, wie auch die Öffnung, meist rechteckig ausgebildet und wird in diesem ersten Schritt linear von einer die Öffnung freigebenden Stellung in eine die Öffnung überdeckende Zwischenstellung geschoben. In dieser Zwischenstellung befindet sich der Ventilteller des Pendel- oder Schieberventils in einer beabstandeten Gegenüberlage zu dem die Öffnung umgebenden Ventilsitz. In einem zweiten Schritt wird der Abstand zwischen dem Ventilteller und dem Ventilsitz verkleinert, so dass der Ventilteller und der Ventilsitz gleichmässig aufeinander gedrückt werden und die Öffnung im Wesentlichen gasdicht verschlossen wird. Diese zweite Bewegung erfolgt vorzugsweise im Wesentlichen in eine senkrechte Richtung zum Ventilsitz. Die Abdichtung kann z.B. entweder über einen auf der Verschlussseite des Ventiltellers angeordneten Dichtungsring, der auf den die Öffnung umlaufenden Ventilsitz gepresst wird, erfolgen, oder über einen Dichtungsring auf dem Ventilsitz, gegen den die Verschlussseite des Ventiltellers gedrückt wird. Durch den in zwei Schritten erfolgenden Schliessvorgang wird der Abdichtring zwischen dem Ventilteller und dem Ventilsitz kaum Scherkräften, die den Abdichtring zerstören würden, unterworfen, da die Bewegung des Ventiltellers im zweiten Schritt im Wesentlichen geradlinig senkrecht auf den Ventilsitz stattfindet.

Unterschiedliche Dichtvorrichtungen sind aus dem Stand der Technik bekannt, beispielsweise aus der US 6,629,682 B2 (Duelli). Ein geeignetes Material für Dichtungsringe und Dichtungen bei Vakuumventilen ist beispielsweise Fluorkautschuk, auch FKM genannt, insbesondere das unter dem Handelsnamen "Viton" bekannte Fluorelastomer, sowie Perfluorkautschuk, kurz FFKM.

Aus dem Stand der Technik sind unterschiedliche Antriebssysteme zur Erzielung diese Kombination einer beim Pendelventil rotatorischen und beim Schieberventil translatorischen Bewegung des Ventiltellers parallel über die Öffnung und einer im Wesentlichen translatorischen Bewegung senkrecht auf die Öffnung bekannt, beispielsweise aus der US 6,089,537 (Olmsted) für ein Pendelventil und aus der US 6,416,037 (Geiser) für ein Schieberventil.

Das Anpressen des Ventiltellers auf den Ventilsitz muss derart erfolgen, dass sowohl die geforderte Gasdichtigkeit innerhalb des gesamten Druckbereichs sichergestellt ist, als auch eine Beschädigung des Abdichtmediums, insbesondere des Abdichtrings in Form eines O-Rings, durch zu grosse Druckbeanspruchung vermieden wird. Um dies zu gewährleisten, sehen bekannte Ventile eine in Abhängigkeit von der zwischen den beiden Ventiltellerseiten herrschenden Druckdifferenz geregelte Anpressdruckregelung des Ventiltellers vor. Besonders bei grossen Druckschwankungen oder dem Wechsel von Unterdruck auf Überdruck, oder umgekehrt, ist eine gleichmässige Kraftverteilung entlang des gesamten Umfangs des Abdichtrings jedoch nicht immer gewährleistbar. Generell wird angestrebt, den Abdichtring von Abstützkräften, die sich aus dem an das Ventil anliegenden Druck ergeben, zu entkoppeln. In der US 6,629,682 (Duelli) wird hierzu z.B. ein Vakuumventil mit einem Abdichtmedium vorgeschlagen, das sich aus einem Abdichtring und einem danebenliegenden Abstützring zusammensetzt, so dass der Abdichtring von Abstützkräften im Wesentlichen befreit ist.

Um die geforderte Gasdichtigkeit, gegebenenfalls sowohl für Über- als auch Unterdruck, zu erreichen, sehen zusätzlich oder alternativ zum zweiten Bewegungsschritt manche bekannte Pendelventile oder Schieberventile einen senkrecht zum Ventilteller verschiebbaren, die Öffnung umgebenden Ventilring vor, der zum gasdichten Schliessen des Ventils auf den Ventilteller gedrückt wird. Derartige Ventile mit relativ zum Ventilteller aktiv verschiebbaren Ventilringen sind beispielsweise aus der DE 1 264 191 B1, der DE 34 47 008 C2, der US 3,145,969 (von Zweck) und der DE 77 31 993 U bekannt. In der US 5,577,707 (Brida) wird ein Pendelventil mit einem eine Öffnung aufweisenden Ventilgehäuse und einem parallel über die Öffnung schwenkbaren Ventilteller zum Steuern eines Durchflusses durch die Öffnung beschrieben. Ein Ventilring, der die Öffnung umschliesst, ist senkrecht in Richtung zum Ventilteller mittels mehrerer Federn und Druckluftzylinder aktiv bewegbar. Eine mögliche Weiterentwicklung dieses Pendelventils wird in der US 2005/0067603 A1 (Lucas et al.) vorgeschlagen.

Da oben genannte Ventile unter anderem bei der Herstellung hochsensibler Halbleiterelemente zum Einsatz kommen, muss die insbesondere durch die Betätigung des Ventils und durch die mechanische Belastung des Ventilverschlussgliedes verursachte Partikelgenerierung und die Anzahl der freien Partikel im Ventilraum möglichst gering gehalten werden. Die Partikelgenerierung ist primär eine Folge von Reibung beispielsweise durch Metall-Metall-Kontakt und durch Abrasion.

Wie oben beschrieben werden Vakuumregelventile zur Einstellung einer definierten Prozessumgebung in einer Prozesskammer eingesetzt. Die Regelung erfolgt hier typischerweise anhand eines Drucksignals, welches eine Information über den Kammerinnendruck bereitstellt, und anhand einer Zielgrösse, d.h. eines Solldrucks, die mittels der Regelung erreicht werden soll. Die Stellung eines Ventilverschlusses (Ventilteller) wird dann im Rahmen der Regelung so variiert, dass innerhalb eines bestimmten Zeitraums der Solldruck erreicht wird.

In einem solchen Regelprozess besteht das Problem, dass im Falle unerwünschter äusserer Einwirkungen in den Prozess die Regelung dennoch allein anhand der aktuellen Druckgrösse erfolgt und dadurch eine nachteilhafte äussere Einwirkung einfach "überregelt" und somit nicht festgestellt wird. Beispielsweise kann bei Vorliegen eines Lecks der Prozesskammer durch die Regelung weiterhin der Solldruck eingestellt werden, wobei jedoch das Gasgemisch in der Prozesskammer nicht länger bestimmten Sollvorgaben entspricht.

Der Erfindung liegt somit die Aufgabe zugrunde, ein verbessertes Vakuumventil mit Regelung bereitzustellen, welches einerseits einen (druck-) geregelten Betrieb einer Prozesskammer ermöglicht und andererseits einer Erhöhte Verlässlichkeit für die geforderte Qualität des Regelprozesses bereitstellt.

Insbesondere ist es Aufgabe der Erfindung anhand eines Ventilsystems eine Überprüfung der ablaufenden Regelung bzw. eines Bearbeitungsprozesses bereitzustellen.

Diese Aufgaben werden durch die Verwirklichung der kennzeichnenden Merkmale der unabhängigen Ansprüche gelöst. Merkmale, die die Erfindung in alternativer oder vorteilhafter Weise weiterbilden, sind den abhängigen Patentansprüchen zu entnehmen.

Die grundlegende Idee der vorliegenden Erfindung ist einen ausgeführten Regelprozess zu protokollieren und die dabei erfassten Daten mit Solldaten für den Regelprozess zu vergleichen. Daraus lassen sich in Folge Aussagen bezüglich des Prozessverlaufs ableiten und auf etwaige Abweichungen von einer definierten Sollregelung schliessen. Insbesondere können hiermit zum einen abrupte Störungen eines Bearbeitungsprozesses festgestellt, jedoch auch langfristige Veränderungen der Prozessbedingungen (z.B. aufgrund eines Drifts) erkannt werden.

Die Erfindung betrifft ein Ventilsystem aus einem Vakuumventil zur Regelung eines Volumen- oder Massenstroms und zum gasdichten Unterbrechen eines Fliesswegs bzw. zum gasdichten Abschluss eines Prozessvolumens und aus einer Regeleinheit. Das Vakuumventil weist einen Ventilsitz auf, der eine eine Öffnungsachse definierende Ventilöffnung und eine die Ventilöffnung umlaufende erste Dichtfläche aufweist. Zudem verfügt das Vakuumventil über einen Ventilverschluss, z.B. Ventilteller, zum im Wesentlichen gasdichten Verschliessen der Ventilöffnung mit einer zweiten zu der ersten Dichtfläche korrespondierenden Dichtfläche oder Einstellen einer aktuellen Grösse der Öffnung.

Ferner ist eine mit dem Ventilverschluss gekoppelte Antriebseinheit vorgesehen, die derart ausgebildet ist, dass der Ventilverschluss zur Bereitstellung von jeweiligen Ventilöffnungszuständen, die von jeweiligen Zuständen des Ventilverschlusses (z.B. einer Position oder Winkelstellung des Verschlusses relativ zum Ventilsitz oder Ventilgehäuse) abhängen, definiert variierbar und einstellbar ist und dass der Ventilverschluss von einer Offenposition, in welcher der Ventilverschluss die Vakuumventilöffnung zumindest teilweise freigibt, in eine Schliessposition, in welcher die erste Dichtfläche des Ventilsitzes auf die zweite Dichtfläche angedrückt ist und die Vakuumventilöffnung im Wesentlichen gasdicht verschliesst, und zurück verstellbar ist.

Insbesondere kann das Verstellen des Verschlusses zumindest im Wesentlichen entlang einer geometrischen Längsachse in eine Längsschliessrichtung erfolgen, und/oder kann der Verschluss durch insbesondere um eine parallel zur Längsachse verlaufende geometrische Schwenkachse in eine Querschliessrichtung in eine Zwischenposition, in welcher der Ventilverschluss die Vakuumventilöffnung überdeckt und sich eine Verschlussseite des Ventilverschlusses in einer beabstandeten Gegenüberlage zum Ventilsitz befindet, und zurück verstellbar sein (vgl. Pendelventil).

Die Regeleinheit des Ventilsystems ist ausgebildet zur Ausführung eines eine gezielte Variation bzw. Einstellung des Ventilöffnungszustands bereitstellenden Regelprozesses durch Ansteuerung der Antriebseinheit basierend auf einer aktuell bestimmten Regelgrösse für einen Prozessparameter und basierend auf einer Zielgrösse, insbesondere wodurch die Regelgrösse an die Zielgrösse durch eine so bewirkte Zustandsänderung des Ventilverschlusses annäherbar ist.

Erfindungsgemäss weist die Regeleinheit eine Überprüfungsfunktionalität zur Überwachung des Regelprozesses auf, wobei die Überprüfungsfunktionalität derart konfiguriert ist, dass bei Ausführung der Überprüfungsfunktionalität im Rahmen der Ausführung des Regelprozesses eine Serie von Zuständen des Ventilverschlusses über zumindest einen Zeitabschnitt des Regelprozesses erfasst wird und diese als aktuelle Regeldaten (z.B. aktuelle Regelkurve oder aktueller Regelverlauf) gespeichert werden. Die aktuellen Regeldaten werden mit bestimmten Sollregeldaten verglichen und basierend auf dem Vergleich der aktuellen Regeldaten mit den Sollregeldaten wird eine Prozessinformation erzeugt.

Die Überwachung des Regelprozesses kann also beispielsweise anhand von Daten über einen gesamten Regelzyklus oder mittels Daten, die innerhalb eines Teilzeitabschnittes des Zyklus erfasst wurden, erfolgen. Hierzu wird im Rahmen der Überwachung ein entsprechendes Vergleichen von aktuellen Regeldaten mit Sollregeldaten gewährleistet, die jeweils einem korrespondierenden Zeitabschnitt zuzuordnen sind. Z.B. kann der Vergleich auf Basis eines Teils einer Regelkurve durchgeführt werden und dieser Kurventeil wird dahingehend geprüft ob dieser mit einem Teil eines Sollregelbereichs vereinbar ist, insbesondere ob der Kurventeil durchgehend in den Grenzen des Sollregelbereichs liegt.

Insbesondere ist der Prozessparameter durch eine Druckinformation für das Prozessvolumen verkörpert, wobei die Zielgrösse einen Solldruck für einen bestimmten Betriebszustand des Prozessvolumens angibt und die aktuell bestimmte Regelgrösse ein aktueller Druck im Prozessvolumen ist. Durch den Regelprozess wird also der Druck in der Prozesskammer so eingeregelt, dass dieser möglichst dem Solldruck entspricht. Dieses Regeln kann zudem unter Vorgabe einer bestimmten Regelzeitdauer geschehen, d.h. die Regelung wird so ausgeführt dass der gewünschte Solldruck nach einer bestimmten Zeitdauer, beginnend mit einem Startsignal für die Regelung, z.B. ein den Beginn des Einströmens eines Prozessgases anzeigendes Signal, eingestellt ist bzw. sein soll.

Gemäss einer Ausführungsform der Erfindung ist die Zielgrösse ein Solldruck für einen bestimmten Betrieb des Prozessvolumens und die aktuell bestimmte Regelgrösse gibt einen aktuellen Medienzufluss in das Prozessvolumen an, insbesondere wobei die aktuell bestimmte Regelgrösse durch eine aktuelle Druckeinlassgrösse verkörpert ist. Die Druckeinlassgrösse kann z.B. einen Massenstrom pro Zeiteinheit darstellen oder eine Information über die Offenstellung eines Einlassventils bilden.

Generell ist zur Durchführung eines Fertigungsschrittes unter Vakuum- bzw. Niederdruckbedingungen ein Solldruck oder eine Sollkurve für den Druckverlauf für ein spezifisches Prozessgas in dem hierfür vorgesehenen Prozessvolumen vorgegeben. Dieser Solldruck bzw. diese Kurve soll im Rahmen der Druckregelung abgebildet werden.

In einer Ausführungsform der Erfindung weist die Regeleinheit eine Lernfunktionalität zur Erzeugung der Sollregeldaten auf, wobei die Lernfunktionalität derart konfiguriert ist, dass bei deren Ausführung für eine Durchführung von einer Anzahl von Regelzyklen insbesondere entsprechend eines Sollbetriebs für den Regelprozess jeweilige Sollzustände des Ventilverschlusses über zumindest je einen Zeitabschnitt eines jeweiligen Regelzyklus erfasst werden und die erfassten Sollzustände des Ventilverschlusses mit Bezug zu jeweiligen Zeitabschnitten des Regelzyklus als die Sollregeldaten gespeichert werden.

Im Rahmen der Lernfunktion können einzelne Regelkurven für jeweilige Regelzyklen erfasst werden und diese Anzahl Regelkurven können zu einer Sollregelkurve zusammengefasst werden. Das Zusammenfassen kann z.B. mittels Ausgleichsrechnung oder Mittelwertbildung anhand der einzelnen Kurven erfolgen. Die Sollregelkurve repräsentiert hierbei die Sollregeldaten.

Alternativ oder zusätzlich kann mittels der erfassten Ventilzustände ein Sollregelbereich definiert werden, z.B. können für jeweilige Regelzeitpunkte jeweils zulässige Positionsbereiche für die Ventilstellung definiert werden. Der Sollregelbereich kann damit ebenso die Sollregeldaten repräsentieren.

Insbesondere kann im Rahmen der Erfindung durch den Vergleich der aktuellen Regeldaten mit den bestimmten Sollregeldaten die Prozessinformation so erzeugt werden, dass die Prozessinformation eine Information bezüglich einer Prozessintegrität für den Regelprozess aufweist.

Insbesondere ist basierend auf der Prozessinformation ein unerwünschter Prozesszustand identifizierbar, insbesondere ein unerwünschter Messenzustrom während des Regelprozesses, insbesondre wobei die Existenz eines Lecks des Prozessvolumens identifizierbar ist.

Die Regeldaten bzw. Sollregeldaten repräsentieren vorzugsweise den Verlauf des jeweiligen (Soll-) Regelprozesses und/oder sind vorzugsweise in Form einer Regelkurve erfasst.

Gemäss einer Ausführungsform der Erfindung weist die Prozessinformation ein Ausgabesignal auf und das Ausgabesignal ist akustisch oder visuell erzeugt. Das Signal kann insbesondere ein Warnsignal sein. Die Prozessinformation kann auch eine eine Qualität für den Regelprozess angebende Qualitätsinformation aufweisen, wobei anhand dieser Qualitätsinformation eine Benutzerausgabe, insbesondere eine Fehlerinformation oder ein Alarmsignal, erzeugbar ist.

In einer Ausführungsform ist mit der aktuelle bestimmten Regelgrösse eine Austrittsinformation hinterlegt oder wird diese aktuell bestimmt, wobei die Austrittsinformation angibt, welche Masse oder welches Volumen eines Mediums aus dem Prozessvolumen pro Zeiteinheit und in Abhängigkeit des Zustandes des Ventilverschlusses abströmt. Diese Information kann insbesondere zusammen mit dem Wissen über einen Zustrom in das Volumen eine geeignete Stellgrösse für ein gewünschtes Regelverhalten bilden.

Neben der Überwachung des Prozesses kann die Überprüfungsfunktionalität ferner derart konfiguriert sein, dass in Abhängigkeit der Prozessinformation eine automatische Anpassung des Regelprozesses durch gezielte Änderung der aktuell bestimmten Regelgrösse oder der Zielgrösse, insbesondere durch Setzen eines Offsets, erfolgt. In anderen Worten kann durch die Überprüfungsfunktionalität in den Regelprozess eingegriffen werden und z.B. anstelle eines tatsächlich gemessenen Druckwertes ein angepasster, virtueller Wert für den Druck in der Prozesskammer dem System zugeführt werden. Der Regler wird dann anhand dieser künstlichen Druckwerte die Regelung der Ventilstellung vornehmen und entsprechend angepasst einstellen.

Als Zustand des Ventilverschlusses wird insbesondere eine durch die Antriebseinheit bewirkte Position des Ventilverschlusses erfasst. Hierbei handelt es sich vorzugsweise um eine Stellung des Ventilverschlusses, also z.B. eines Ventiltellers, relativ zum Ventilsitz bzw. zum Ventilgehäuse. Diese Position kann z.B. mittels eines Encoders seitens der Antriebseinheit (z.B. am Motor) oder seitens des Ventils selbst festgestellt werden.

Alternativ oder zusätzlich kann als ein aktueller Zustand des Ventilverschlusses ein aktueller Öffnungsquerschnitt der Ventilöffnung z.B. in Abhängigkeit der Ventilverschlussstellung angegeben werden.

Insbesondere sind das Vakuumventil und die Regeleinheit in integrierter Bauweise ausgeführt. Die beiden Elemente sind also als eine Einheit ausgebildet und sind z.B. in einem gemeinsamen Gehäuse realisiert.

Alternativ kann die Regeleinheit strukturell getrennt von dem Vakuumventil ausgebildet sein und in Kommunikationsverbindung mit dem Vakuumventil stehen, insbesondere wobei eine drahtlose Funkverbindung (WLAN, Bluetooth etc.) oder eine drahtgebundene Verbindung besteht. Die Regeleinheit kann z.B. als separater Controller ausgebildet sein, welcher die Regelgrössen, Zielgrössen und ggf. ein Feedback bezüglich der Stellung des Ventilverschlusses erhält und anhand dieser Inputdaten und anhand der Kenntnis über die gewünschte Regelung ein Ansteuerungsausgabesignal für den Motor des Ventils berechnet und zur Verfügung stellt, insbesondere direkt an den Motor übermittelt.

In einer spezifischen Anordnung kann die Regeleinheit mit einem Drucksensor verbunden sein und ein Ausgangssignal des Drucksensors stellt die aktuell bestimmte Regelgrösse bereit. Der Drucksensor ist insbesondere so angeordnet, dass damit der Druck im Inneren der Prozesskammer, insbesondere fortlaufend oder mit einer bestimmten Aktualisierungsfrequenz, gemessen werden kann. Diese Druckinformation kann dann als Sensorausgangssignal in das Regelsystem geleitet und darin weiterverarbeitet werden.

Die Regeleinheit kann ferner beispielsweise mit einem Massenströmungsmesser oder einer Massenströmungskontrolleinheit (eng. "gas flow meter" oder "mass flow controller") verbunden sein, wobei ein Ausgangssignal des Massenströmungsmesser bzw. der Massenströmungskontrolleinheit die aktuell bestimmte Regelgrösse bereitstellt. D.h. die Regelung der Ventilstellung kann auch anhand einer Information bezüglich eines in eine Prozesskammer strömenden Gases erfolgen. So kann der Öffnungsquerschnitt des Ventils so eingestellt werden, dass eine Menge Gas pro Zeiteinheit abfliesst, die an einen Gaszufluss angepasst ist, insbesondere diesem entspricht.

Die Erfindung betrifft ausserdem ein Verfahren zur Überprüfung eines geregelten Betriebs eines Vakuumventils, wobei das Vakuumventil zur Regelung eines Volumen- oder Massenstroms und zum gasdichten Abschluss eines Prozessvolumens ausgebildet ist. Das Vakuumventil weist einen Ventilsitz auf, der eine eine Öffnungsachse definierende Ventilöffnung und eine die Ventilöffnung umlaufende erste Dichtfläche aufweist. Ferner ist ein Ventilverschluss zum im Wesentlichen gasdichten Verschliessen der Ventilöffnung mit einer zweiten zu der ersten Dichtfläche korrespondierenden Dichtfläche vorgesehen. Zudem verfügt das Ventil über eine mit dem Ventilverschluss gekoppelte Antriebseinheit, die derart ausgebildet ist, dass der Ventilverschluss zur Bereitstellung von jeweiligen Ventilöffnungszuständen, die von jeweiligen Zuständen des Ventilverschlusses (38) abhängen, definiert variierbar und einstellbar ist und von einer Offenposition, in welcher der Ventilverschluss die Vakuumventilöffnung zumindest teilweise freigibt in eine Schliessposition, in welcher die erste Dichtfläche des Ventilverschlusses auf die zweite Dichtfläche angedrückt ist und die Vakuumventilöffnung im Wesentlichen gasdicht verschliesst, und zurück verstellbar ist.

Insbesondere ermöglicht die Antriebseinheit ein Verstellen zumindest im Wesentlichen entlang einer geometrischen Längsachse in eine Längsschliessrichtung, und/oder durch eine Beweglichkeit des Ventilverschlusses im Wesentlichen entlang einer oder um ein geometrische Querachse in eine Querschliessrichtung in eine Zwischenposition, in welcher der Ventilverschluss die Vakuumventilöffnung überdeckt und sich eine Verschlussseite des Ventilverschlusses in einer beabstandeten Gegenüberlage zum Ventilsitz befindet, und zurück.

Im Rahmen des Verfahrens wird ein Regelprozesses durch Ansteuerung der Antriebseinheit basierend auf einer aktuell bestimmten Regelgrösse für einen Prozessparameter und einer Zielgrösse ausgeführt, insbesondere wodurch die Regelgrösse an die Zielgrösse durch eine so bewirkte Zustandsänderung des Ventilverschlusses angenähert wird. Hierdurch wird eine gezielte Variation bzw. Einstellung des Ventilöffnungszustands bereitgestellt.

Erfindungsgemäss wird im Rahmen der Ausführung des Regelprozesses eine Serie von Zuständen des Ventilverschlusses über zumindest einen Zeitabschnitt des Regelprozesses erfasst und die Zustände werden als aktuelle Regeldaten (z.B. als Regelkurve) gespeichert. Die aktuellen Regeldaten werden dann mit (vor-)bestimmten (bekannten) Sollregeldaten verglichen und basierend auf dem Vergleich der aktuellen Regeldaten mit den Sollregeldaten wird eine Prozessinformation erzeugt.

Gegenstand der Erfindung ist ferner ein Computerprogrammprodukt das auf einem maschinenlesbaren Träger gespeichert ist, insbesondere in einer Speichereinheit eines oben beschriebenen Ventilsystems. Das Computerprogrammprodukt weist Programmcode zur Durchführung bzw. Steuerung zumindest der folgenden Schritte des obigen Verfahrens auf:
- Ausführen eines Regelprozesses,
- Erfassen der Serie von Zuständen des Ventilverschlusses als aktuelle Regeldaten,
- Vergleichen der aktuellen Regeldaten mit bestimmten Sollregeldaten und
- Erzeugen der Prozessinformation,

Insbesondere wird das Programm in einer elektronischen Datenverarbeitungseinheit, insbesondere der Regeleinheit, eines Ventilsystems ausgeführt. Es kann also eine Überprüfung eines Regelprozesses durch Ausführung eines entsprechenden (computerimplementierten) Algorithmus erfolgen.

Die erfindungsgemässe Vorrichtung und das erfindungsgemässe Verfahren werden nachfolgend anhand von in den Zeichnungen schematisch dargestellten konkreten Ausführungsbeispielen rein beispielhaft näher beschrieben, wobei auch auf weitere Vorteile der Erfindung eingegangen wird. Im Einzelnen zeigen:
- Fig. 1: eine schematische Darstellung einer ersten Ausführungsform eines erfindungsgemässen Vakuumsystems zum geregelten Betrieb einer Prozesskammer;
- Fig. 2: ein Vergleich einer aktuell erfassten Regelkurve mit einer Sollregelkurve gemäss der Erfindung; und
- Fig. 3a-c: eine Ausführungsform eines Regelventils als Pendelventil.

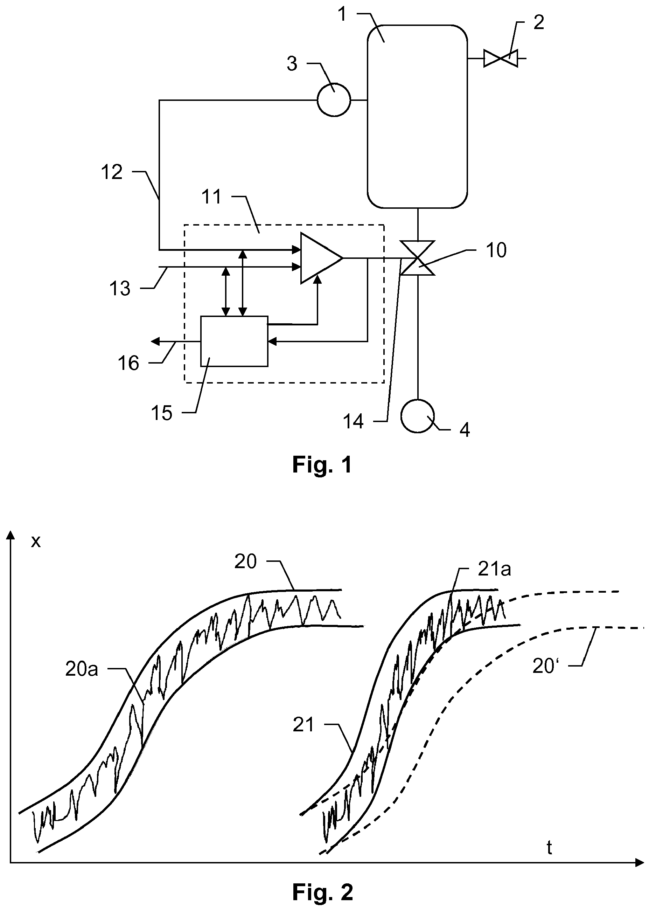

Figur 1 zeigt schematisch einen Aufbau eines Prozesssystems zur Bearbeitung eines Objekts unter Vakuumbedingungen. Der Aufbau weist eine Prozesskammer 1 und eine Zuleitung in die Prozesskammer auf, wobei die Zuleitung mit einem Gasdurchflussmesser bzw. -regler 2 versehen ist und damit eine Gasmenge, die in die Prozesskammer strömt, gemessen oder die einströmende Gasmenge entsprechend geregelt werden kann. Ferner ist ein Drucksensor 3 vorgesehen, welcher eine Bestimmung des Drucks im Inneren der Prozesskammer (Kammerdruck) erlaubt.

An einer Auslassseite der Prozesskammer 1 ist eine Vakuumpumpe 4 mit der Kammer 1 zu deren Evakuierung verbunden. Zwischen der Vakuumpumpe 4 und der Kammer 1 ist ein einstellbares Vakuumventil 10 zur Steuerung bzw. Regelung des abfliessenden Massenstroms angeordnet. Die (gesteuerte) Einstellbarkeit kann hierbei z.B. mittels eines motorisierten, pneumatischen oder hydraulischen Antriebs des Ventils realisiert sein.

Das System weist erfindungsgemäss eine Regeleinheit 11 auf, die mit dem Ventil 10 verbunden ist und eine geregelte Ansteuerung des Ventils 10 anhand einer entsprechenden Inputgrösse 12 und einer Sollgrösse 13 bereitstellt.

In der gezeigten Ausführungsform wird fortlaufend als Inputgrösse 12, d.h. als aktuell bestimmte Regelgrösse, ein aktuelles Drucksignal 12 des Drucksensors 3 erhalten womit ein aktueller Druckzustand in der Prozesskammer 1 bekannt bzw. bereitgestellt ist. Der Regeleinheit 11 wird zudem als Soll- oder Zielgrösse 13 ein Solldruck oder eine Solldruckverlauf für einen jeweiligen Bearbeitungsprozess bereitgestellt. Anhand dieser Eingangsgrössen wird mit der Regeleinheit 11 ein Stellsignal 14 erzeugt und an das motorisierte Ventil 10 ausgegeben.

Zur Einstellung eines gewünschten Innendrucks in der Prozesskammer 1 wird im Rahmen eines Regelzyklus also die Ventilöffnung des Vakuumventils 10 so variiert, dass ein Gasabfluss aus der Prozesskammer so erfolgt, dass der aktuelle Innendruck an einen Zieldruck angenähert werden kann. Beispielsweise wird in einem ersten Zeitabschnitt eines Bearbeitungsprozesses die Ventilöffnung verhältnismässig weit geöffnet eingestellt, damit eine möglichst schnelle Absenkung des Innendrucks erfolgt und im weiteren Verlauf der Regelung die Ventilöffnung weniger weit geöffnet eingestellt, damit in einen spätren Zeitabschnitt der gewünschte Innendruck durch ein kontrolliertes Abfliessen einer kleineren Gasmenge pro Zeiteinheit eingestellt und gehalten werden kann, wobei insbesondere eine laminare oder molekulare Gasströmung oder aber auch eine Mischform aus beidem vorliegt.

Durch das variieren der Ventilposition, d.h. der Position des Ventilverschlusses relativ zur Ventilöffnung, wird für jeden Regelzyklus ein Regelungsverlauf, insbesondere eine Regelkurve, definiert, also Ventilpositionen zu jeweiligen Zeitpunkten in einem bestimmten Zeitintervall. Ein Bearbeitungsprozess in einer Prozesskammer wird typischerweise vielfach wiederholt in Regelzyklen ausgeführt, wobei die Druckregelung dann jeweils entsprechend gleichartig ausgeführt werden soll.

Erfindungsgemäss weist die Regeleinheit zur Verifizierung der Prozessintegrität und/oder -qualität eine Überprüfungs- bzw. Überwachungsfunktionalität 15 auf. Mit dieser Funktionalität ist eine Sollregelung definiert, die eine Vorschrift dafür bildet, wie ein Regelzyklus durchgeführt werden soll. Die Sollregelung kann z.B. in Form einer Sollregelkurve hinterlegt sein.

Anhand der Information über einen Sollverlauf der Regelung kann nun ein aktuell erfasster Regelungsverlauf mit dem Sollverlauf verglichen werden und basierend auf diesem Vergleich eine Information abgeleitet werden, ob die Regelung in gesetzten Grenzen, z.B. innerhalb eines Toleranzbereichs, durchgeführt worden ist oder nicht.

Die Regelungseinheit 11 kann ferner eine Lernfunktion aufweisen, mittels derer die Information bezüglich einer Sollregelung erstellet werden kann. Hierzu wird ein Produktionszyklus mehrere Male mit gesetzten Sollbedingungen (z.B. Solldruck, Solltemperatur, Druckverlauf, Temperaturverlauf etc) ausgeführt und mit der Regeleinheit 11 der Druck in der Kammer 1 über die Ventilstellung zur Erreichung des Solldrucks geregelt eingestellt. Während des Durchfahrens dieser Produktionszyklen werden die Ventilstellungen in den einzelnen Zyklen über die Regelzeit gespeichert. Aus der so erzeugbaren Datenmenge wird dann, z.B. mittels Ausgleichsrechung oder Modellierung, eine die einzelnen Datensätze (ein Datensatz je Regelzyklus) vereinende Sollregelinformation abgeleitet.

Die Überprüfungsfunktionalität 15 kann ferner dazu ausgebildet sein in Abhängigkeit eines erfassten aktuellen Regelverlaufs eine Anpassung der zu erreichenden Zielgrösse vorzunehmen, um beispielsweise den Regelprozess derart zu beeinflussen, dass eine festgestellte Abweichung in der Regelung bei nachfolgenden Regelzyklen ausgeglichen wird. In anderen Worten, kann die Überprüfungsfunktionalität 15 die Zielgrösse insbesondere zeitabhängig verändert ausgeben und in dieser Form in den Regelkreis einbringen.

In ähnlicher Wiese kann die Überprüfungsfunktionalität 15 entsprechend auf die aktuell gemessene Regelgrösse (z.B. gemessener Druck) einwirken. Z.B. kann das Vorliegen ein grösseren Drucks als tatsächlich gemessen simuliert werden, um ein schnelleres Absenken des Innendrucks zu bewirken.

Ein Eingriff in den Regelprozess mittels der Überprüfungsfunktionalität 15 kann insbesondere mittels direkten Inputs in den Regler erfolgen, z.B. durch Anpassen von Regelparametern.

Das Überprüfungsmodul 15 verfügt zudem über einen Ausgabekanal 16. Hiermit kann ein Signal ausgegeben werden, das eine Information über den aktuellen Regelzustand aufweist. So kann ein Benutzer beispielsweise erkennen, ob der Prozess in dessen vorgegebenen Grenzen abläuft oder Abweichungen hiervon vorliegen. Alternativ oder ergänzend kann das Signal einer Recheneinheit oder übergeordneten Prozesssteuerung bereitgestellt werden, wodurch z.B. automatische Anpassungen eines Gesamtprozesses vorgenommen werden können.

Durch die erfindungsgemässe Überprüfungsfunktionalität lässt sich somit nicht nur prüfen, ob ein für das Ventil 10 vorgesehener Regelprozess eingehalten wird, sondern es kann darüber hinaus eine Aussage getroffen werden, ob der Bearbeitungsprozess selbst im Rahmen seiner definierten Randbedingungen abläuft. Wird z.B. eine Abweichung zwischen einer aktuelle aufgenommenen Regelkurve und der für den Prozess hinterlegten Sollregelkurve festgestellt, so kann anhand dieser Abweichung beispielsweise auf das Vorliegen eines Lecks in der Prozesskammer oder einer Zuleitung zur Prozesskammer geschlossen werden und der Prozess entsprechend als fehlerhaft gekennzeichnet werden. Ohne die erfindungsgemässe Überprüfungsfunktionalität würde ein solches Leck einfach "überregelt" werden, d.h. das Ventil würde entsprechend derart angesteuert werden, dass in einer vorgegebenen Zeit der Solldruck erreicht wird, ohne dass zunächst äusserlich ein Mangel im Prozessverlauf festgestellt werden würde.

Die Figur 2 zeigt einen für einen Regelzyklus definierten Sollregelbereich 20 und eine für diesen Regelprozess erfasste aktuelle Regelung 21a.

Innerhalb des Sollregelbereichs 20 ist exemplarisch eine Regelkurve 20a dargestellt, die aus einer Anzahl einzeln erfasster Regelkurven im Rahmen von Lernprozessen für einen auszuführenden Bearbeitungsschritt abgeleitete wurde. Anhand des Verlaufs dieser Kurve 20a, ist eine Einhüllende für die Kurve 20a erzeugt, welche wiederum einen Toleranzbereich 20 für eine gewünschte Regelung definiert. Die erfassten Regelkurven aus dem Lernprozess und auch die dargestellte abgeleitete Kurve 20a repräsentieren jeweils durch die Antriebseinheit (Motor, Pneumatik, Hydraulik etc.) eingestellte Ventilpositionen (x,y) oder (Winkel-) Stellungen (°) über die Zeit (t) eines Regelzyklus.

Die Regelung, die mit der Kurve 21a dargestellt ist, repräsentiert einen aktuellen, unabhängig von dem Lernprozess ausgeführten Produktionsregelzyklus. Anhand der hier ebenfalls dargestellten Einhüllenden 21 für diese Kurve 21a ist die gegebene Abweichung des ausgeführten Regelprozesses ersichtlich. Die Kurve 21a liegt nicht innerhalb des hier mit 20' bezeichneten zulässigen Regelbereichs, der im Verlauf dem Sollregelbereich 20 entspricht und entlang der Zeitachse zur visuellen Überprüfung der Kurve 21a verschoben ist, also den Sollregelbereich 20 repräsentiert.

Festgestellt werden kann anhand eines Vergleichs des Verlaufs der Bereiche 20/20' und 21 bzw. der Kurven 20a und 21a, dass im aktuellen Regelvorgang ein deutlich schnelleres Verstellen des Ventilverschlusses erfolgt, also eine schnellere Veränderung der Verschlussposition über die Zeit als in der Sollregelung vorgesehen. Eine solche Verlaufsabweichung kann ein Hinweis auf einen geringeren Druckanstieg im Prozessvolumen sein als erwartet, was z.B. aufgrund einer Fehlfunktion des Gasmengenreglers auftreten kann.

Alternativ kann eine Verlaufsabweichung ein Hinweis auf das Vorliegens eines Gaslecks sein, wenn z.B. in kürzerer Zeit eine grössere Gasmenge aus dem Prozessvolumen extrahiert werden muss, z.B. mit einer länger andauernden Offenstellung des Ventils. Ein solcher Fall ist typischerweise mit einem langsameren Anstieg der Regelkurve verbunden.

Die Grenzen für den zulässigen Sollregelbereich 20 können wie oben beschrieben mittels einer Referenzkurve (z.B. 20a) für den Ablauf einer Sollregelung bestimmt werden, indem z.B. ein die Kurve einhüllender Bereich gesetzt wird. Der Bereich kann dabei eine gewisse Toleranz in Bezug zur Kurve aufweisen, d.h. der Bereich kann von jeweiligen lokalen oder globalen Maxima oder Minima der Kurve einen bestimmten Abstand aufweisen.

Alternativ kann der Sollregelbereich 20 beispielsweise durch Modellierung oder Simulierung eines Regelvorgangs festgelegte werden, wobei z.B. ein zu erwartender Gaszufluss, eine darauf beruhende Druckänderung und der hierzu bereitzustellende Gasabfluss simuliert oder berechnet werden. In einem einfacheren Fall kann in Kenntnis der einströmenden Gasmenge (in Abhängigkeit der Zeit) und insbesondere der Systemaufbaus direkt die Sollregelkurve für das Ventil bestimmt werden.

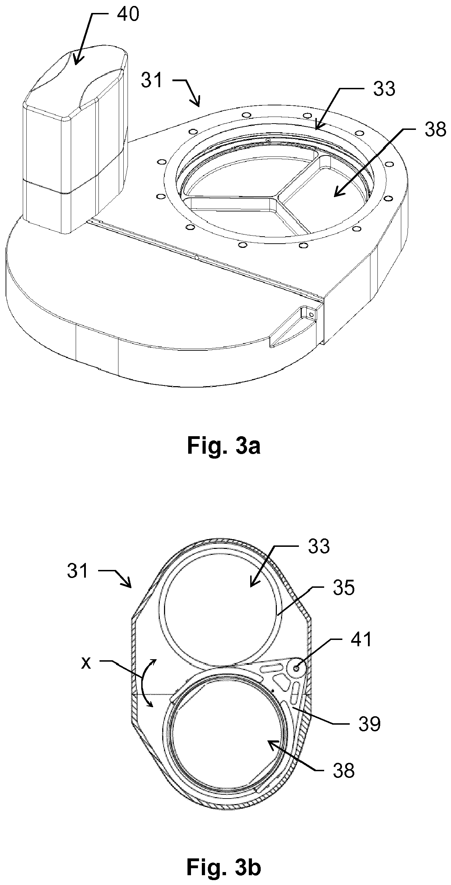

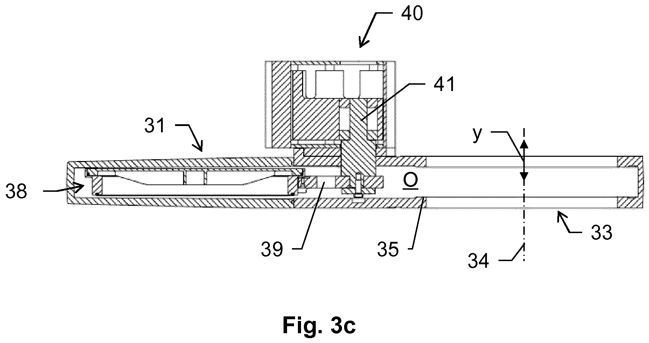

In den Figuren 3a bis 3c ist eine mögliche Ausführungsform des erfindungsgemässen Ventils in Form eines Pendelventils dargestellt. Das Ventil zum im Wesentlichen gasdichten Unterbrechen eines Fliesswegs besitzt ein Ventilgehäuse 31, welches eine Öffnung 33 aufweist. Die Öffnung hat einen kreisrunden Querschnitt. In einer Geschlossenstellung des Ventiltellers 38, ist die Öffnung 33 mittels des Ventiltellers 38 gasdicht verschlossen. Eine Offenstellung O des Ventiltellers 38 ist in den Figuren 3b und 3c veranschaulicht.

Die Öffnung 33 wird von einem Ventilsitz umschlossen. Dieser Ventilsitz wird von einer axial in Richtung des Ventiltellers 38 weisenden und quer zur Öffnungsachse 34 verlaufenden, die Form eines Kreisrings aufweisenden Dichtfläche 35, welche im Ventilgehäuse 31 ausgeformt ist, gebildet.

Ausserdem besitzt das Ventil einen schwenkbaren und zudem im Wesentlichen parallel zur Öffnungsachse 34 verstellbaren Ventilteller 38.

Der Ventilteller 38 ist über einen seitlich an dem Teller angeordneten, sich senkrecht zur Öffnungsachse 34 erstreckenden Arm 39 mit einem elektrischen Antrieb 40 (Motor) verbunden. Dieser Arm 39 befindet sich in der Geschlossenstellung des Ventiltellers 38 ausserhalb des entlang der Öffnungsachse 34 geometrisch projizierten Öffnungsquerschnitts der Öffnung 33.

Ein elektrischer Antrieb 40 ist durch Einsatz eines entsprechenden Getriebes derart ausgebildet, dass der Ventilteller 38 - wie bei einem Pendelventil üblich - mittels einer Querbewegung x des Antriebs 40 quer zur Öffnungsachse 34 und im Wesentlichen parallel über den Querschnitt der Öffnung 33 und senkrecht zur Öffnungsachse 34 in Form einer Schwenkbewegung um eine Schwenkachse 41 zwischen einer Offenstellung O und einer Zwischenstellung schwenkbar und mittels einer parallel zur Öffnungsachse 34 erfolgenden Längsbewegung y des Antriebs 40 linear verschiebbar ist. In der Offenstellung O, ist der Ventilteller 38 in einem seitlich neben der ersten Öffnung 33 angeordneten Verweilabschnitt positioniert, so dass die Öffnung 33 und der Fliessweg freigegeben sind. In der Zwischenstellung ist der Ventilteller 38 über der ersten Öffnung 33 beabstandet positioniert und überdeckt den Öffnungsquerschnitt der Öffnung 33. In der Geschlossenstellung ist die Öffnung 33 gasdicht geschlossen und der Fliessweg unterbrochen, indem ein gasdichter Kontakt zwischen dem Ventilverschluss 38 (Ventilteller) und der Dichtfläche 35 des Ventilsitz besteht.

Um ein automatisiertes und geregeltes Öffnen und Schliessen des Ventils zu ermöglichen, sieht das Ventil eine elektronische Regelung vor, die derart ausgebildet ist und mit dem Antrieb 40 in derartiger Verbindung steht, dass der Ventilteller 38 zum gasdichten Abschliessen eines Prozessvolumens oder zum Regeln eines Innendrucks dieses Volumens entsprechend verstellbar ist. Eine solche Regeleinheit bildet zusammen mit dem Ventil ein Ventilsystem gemäss der Erfindung.

Die Stellung des Ventiltellers 38 wird anhand der Regelgrössen und eines ausgegebenen Steuersignals variabel eingestellt. Als Inputsignal wird eine Information über einen aktuellen Druckzustand in einem mit dem Ventil verbundenen Prozessvolumen erhalten. Zudem kann dem Regler eine weitere Inputgrösse, z.B. ein Massenzustrom in das Volumen, bereitgestellt werden. Anhand dieser Grössen und anhand eines vorgegebenen Solldrucks, der für das Volumen eingestellt bzw. erreicht werden soll, erfolgt dann eine geregelte Einstellung des Ventils über die Zeit eines Regelzyklus, so dass ein Massenabfluss aus dem Volumen mittels des Ventils über die Zeit geregelt werden kann. Hierzu ist hinter dem Ventil eine Vakuumpumpe vorgesehen, d.h. das Ventil ist zwischen der Prozesskammer und der Pumpe angeordnet. Somit kann ein gewünschter Druckverlauf eingeregelt werden.

Durch die Einstellung des Ventilverschlusses 38 wird ein jeweiliger Öffnungsquerschnitt für die Ventilöffnung 33 eingestellt und damit die mögliche Gasmenge eingestellt, die pro Zeiteinheit aus dem Prozessvolumen evakuiert werden kann. Der Ventilverschluss 38 kann zu diesem Zweck eine von einer kreisrunden Form abweichende Form aufweisen, insbesondere um einen möglichst laminaren Medienfluss zu erreichen.

Zur Regelung des Öffnungsquerschnitts ist der Ventilteller 38 durch die Regeleinheit mittels der Querbewegung x des Antriebs 40 von der Offenstellung O in die Zwischenstellung und mittels der Längsbewegung y des Antriebs 40 von der Zwischenstellung in die Geschlossenstellung verstellbar. Zum vollständigen Öffnen des Fliesswegs ist der Ventilteller 38 durch die Steuerung mittels der Längsbewegung y des Antriebs 40 von der Geschlossenstellung in der Zwischenstellung und von dort aus mittels der Querbewegung x des Antriebs 40 von der Zwischenstellung in die Offenstellung O verstellbar.

Im vorliegenden Ausführungsbeispiel ist der Antrieb 40 als ein Elektromotor ausgebildet, wobei das Getriebe derart umschaltbar ist, dass ein Antreiben des Antriebs 40 entweder die Querbewegung x oder die Längsbewegung y bewirkt. Der Antrieb 40 und das Getriebe werden von der Regelung elektronisch angesteuert. Derartige Getriebe, insbesondere mit Kulissenschaltungen, sind aus dem Stand der Technik bekannt. Weiters ist es möglich, mehrere Antriebe zum Bewirken der Querbewegung x und der Längsbewegung y einzusetzen, wobei die Steuerung die Ansteuerung der Antriebe übernimmt.

Das präzise Regeln des Durchflusses mit dem beschriebene Pendelventil ist nicht nur durch das schwenkende Verstellen des Ventiltellers 38 zwischen der Offenstellung O und der Zwischenstellung mittels der Querbewegung x, sondern vor allem durch lineares Verstellen des Ventiltellers 38 entlang der Öffnungsachse 34 zwischen der Zwischenstellung, der Geschlossenstellung mittels der Längsbewegung y möglich. Das beschriebene Pendelventil kann für präzise Regelaufgaben eingesetzt werden.

Sowohl der Ventilteller 38 als auch der Ventilsitz besitzen jeweils eine Dichtfläche 35 - eine erste und eine zweite Dichtfläche. Die erste Dichtfläche 35 weist zudem eine Dichtung auf. Diese Dichtung kann beispielsweise als Polymer mittels Vulkanisation auf den Ventilsitz aufvulkanisiert sein. Alternativ kann die Dichtung z.B. als O-Ring in einer Nut des Ventilsitzes ausgeführt sein. Auch kann ein Dichtmaterial auf den Ventilsitz aufgeklebt sein und dadurch die Dichtung verkörpern. In einer alternativen Ausführungsform kann die Dichtung seitens des Ventiltellers 38, insbesondere auf der zweiten Dichtfläche, angeordnet sein. Auch Kombinationen dieser Ausführungen sind denkbar.

Alternativ zu einem Pendelventil wie dargestellt kann das erfindungsgemässe Vakuumventilsystem mit einem anderen Vakuumventiltyp, z.B. einem Klappventil, Schieberventil oder einem sog. Butterfly-Regelventil, realisiert sein. Insbesondere ist das System mit Druckregelventilen zum Einsatz im Vakuumbereich ausgebildet. Ferner sind ebenso Pendelventile einsetzbar, deren Verschluss nur in einer Richtung verstellt werden kann.

Es versteht sich, dass die dargestellten Figuren nur mögliche Ausführungsbeispiele schematisch darstellen. Die verschiedenen Ansätze können erfindungsgemäss ebenso miteinander sowie mit Verfahren und Vorrichtungen zur Druckregelung für Vakuumprozesse des Stands der Technik kombiniert werden.

## Patentansprüche

1. Ventilsystem aus einem Vakuumventil (10) zur Regelung eines Volumen- oder Massenstroms und zum gasdichten Abschluss eines Prozessvolumens (1) und einer Regeleinheit, wobei das Vakuumventil (10) aufweist
• einen Ventilsitz, der eine eine Öffnungsachse (34) definierende Ventilöffnung (33) und eine die Ventilöffnung (33) umlaufende erste Dichtfläche (35) aufweist,
• einen Ventilverschluss (38) zum im Wesentlichen gasdichten Verschliessen der Ventilöffnung (33) mit einer zweiten zu der ersten Dichtfläche (35) korrespondierenden Dichtfläche und
• eine mit dem Ventilverschluss (38) gekoppelte Antriebseinheit (40), die derart ausgebildet ist, dass der Ventilverschluss (38)
□ zur Bereitstellung von jeweiligen Ventilöffnungszuständen, die von jeweiligen Zuständen des Ventilverschlusses (38) abhängen, definiert variierbar und einstellbar ist und
□ von einer Offenposition (O), in welcher der Ventilverschluss (38) die Ventilöffnung (33) zumindest teilweise freigibt in eine Schliessposition, in welcher die erste Dichtfläche (35) auf die zweite Dichtfläche angedrückt ist und die Ventilöffnung (33) im Wesentlichen gasdicht verschliesst, und zurück verstellbar ist,
und wobei die Regeleinheit ausgebildet ist zur Ausführung eines eine gezielte Variation bzw. Einstellung des Ventilöffnungszustands bereitstellenden Regelprozesses durch Ansteuerung der Antriebseinheit (40) basierend auf einer aktuell bestimmten Regelgrösse (12) für einen Prozessparameter und einer Zielgrösse (13), insbesondere wodurch die Regelgrösse (12) an die Zielgrösse (13) durch eine so bewirkte Zustandsänderung des Ventilverschlusses (38) annäherbar ist,
**dadurch gekennzeichnet, dass**
die Regeleinheit eine Überprüfungsfunktionalität zur Überwachung des Regelprozesses aufweist, die derart konfiguriert ist, dass bei Ausführung der Überprüfungsfunktionalität
• im Rahmen der Ausführung des Regelprozesses eine Serie von Zuständen des Ventilverschlusses (38) über zumindest einen Zeitabschnitt des Regelprozesses erfasst wird und diese als aktuelle Regeldaten (21a) gespeichert wird,
• die aktuellen Regeldaten (21a) mit bestimmten Sollregeldaten (20,20a) verglichen werden und
• basierend auf dem Vergleich der aktuellen Regeldaten (21a) mit den Sollregeldaten (20,20a) eine Prozessinformation erzeugt wird.

2. Ventilsystem nach Anspruch 1,
**dadurch gekennzeichnet, dass**
• der Prozessparameter durch eine Druckinformation für das Prozessvolumen (1) verkörpert ist,
• die Zielgrösse (13) ein Solldruck für einen bestimmten Betrieb des Prozessvolumens (1) ist und
• die aktuell bestimmte Regelgrösse (21a) einen aktuellen Druck im Prozessvolumen (1) repräsentiert.

3. Ventilsystem nach Anspruch 1 oder 2,
**dadurch gekennzeichnet, dass**
• die Zielgrösse (13) ein Solldruck für einen bestimmten Betrieb des Prozessvolumens (1) ist und
• die aktuell bestimmte Regelgrösse (12) einen aktuellen Medienzufluss in das Prozessvolumen (1) angibt, insbesondere wobei die aktuell bestimmte Regelgrösse durch eine aktuelle Druckeinlassgrösse verkörpert ist.

4. Ventilsystem nach einem der Ansprüche 1 bis 3,
**dadurch gekennzeichnet, dass**
die Regeleinheit eine Lernfunktionalität zur Erzeugung der Sollregeldaten (20,20a) aufweist, wobei die Lernfunktionalität derart konfiguriert ist, dass bei deren Ausführung
• für eine Durchführung von einer Anzahl von Regelzyklen entsprechend eines Sollbetriebs für den Regelprozess jeweilige Sollzustände des Ventilverschlusses (38) über zumindest je einen Zeitabschnitt eines jeweiligen Regelzyklus erfasst werden und
• die erfassten Sollzustände des Ventilverschlusses (38) mit Bezug zu jeweiligen Zeitabschnitten des Regelzyklus als die Sollregeldaten (20,20a) gespeichert werden.

5. Ventilsystem nach einem der Ansprüche 1 bis 4,
**dadurch gekennzeichnet, dass**
durch den Vergleich der aktuellen Regeldaten (21a) mit den bestimmten Sollregeldaten (20,20a) die Prozessinformation so erzeugt wird, dass die Prozessinformation eine Information bezüglich einer Prozessintegrität für den Regelprozess aufweist, insbesondere wobei basierend auf der Prozessinformation ein unerwünschter Prozesszustand identifizierbar ist, insbesondere ein unerwünschter Messenzustrom während des Regelprozesses, insbesondre wobei die Existenz eines Lecks des Prozessvolumens (1) identifizierbar ist.

6. Ventilsystem nach einem der Ansprüche 1 bis 5,
**dadurch gekennzeichnet, dass**
die aktuellen Regeldaten (21a) und/oder die Sollregeldaten (20,20a)
• den aktuellen Verlauf bzw. einen Sollverlauf des Regelprozesses repräsentieren und/oder
• in Form einer jeweiligen Regelkurve erfasst sind.

7. Ventilsystem nach einem der Ansprüche 1 bis 6,
**dadurch gekennzeichnet, dass**
die Prozessinformation
• ein Ausgabesignal umfasst und das Ausgabesignal akustisch oder visuell erzeugt ist, und/oder
• eine eine Qualität für den Regelprozess angebende Qualitätsinformation aufweist und anhand dieser Qualitätsinformation eine Benutzerausgabe, insbesondere eine Fehlerinformation oder ein Alarmsignal, erzeugbar ist.

8. Ventilsystem nach einem der Ansprüche 1 bis 7,
**dadurch gekennzeichnet, dass**
mit der aktuelle bestimmten Regelgrösse (12) eine Austrittsinformation hinterlegt ist oder aktuell bestimmt wird, wobei die Austrittsinformation angibt, welche Masse oder welches Volumen eines Mediums pro Zeiteinheit aus dem Prozessvolumen (1) und in Abhängigkeit des Zustandes des Ventilverschlusses (38) abströmt.

9. Ventilsystem nach einem der Ansprüche 1 bis 8,
**dadurch gekennzeichnet, dass**
die Überprüfungsfunktionalität derart konfiguriert ist, dass in Abhängigkeit der Prozessinformation eine automatische Anpassung des Regelprozesses durch gezielte Änderung der aktuell bestimmten Regelgrösse (12) oder der Zielgrösse (13), insbesondere durch Setzen eines Offsets, erfolgt.

10. Ventilsystem nach einem der Ansprüche 1 bis 9,
**dadurch gekennzeichnet, dass**
der Zustand des Ventilverschlusses (38)
• eine durch die Antriebseinheit bewirkte Position des Ventilverschlusses (38) relativ zum Ventilsitz angibt, und/oder
• einen aktuellen Öffnungsquerschnitt der Ventilöffnung (33) in Abhängigkeit der Ventilverschlussstellung angibt.

11. Ventilsystem nach einem der Ansprüche 1 bis 10,
**dadurch gekennzeichnet, dass**
das Vakuumventil (10) und die Regeleinheit in integrierter Bauweise ausgeführt sind.

12. Ventilsystem nach einem der Ansprüche 1 bis 10,
**dadurch gekennzeichnet, dass**
die Regeleinheit strukturell getrennt von dem Vakuumventil (10) ausgebildet ist und in Kommunikationsverbindung mit dem Vakuumventil (10) steht, insbesondere wobei eine drahtlose Funkverbindung oder eine drahtgebundene Verbindung besteht.

13. Ventilsystem nach einem der Ansprüche 1 bis 12,
**dadurch gekennzeichnet, dass**
die Regeleinheit verbunden ist
• mit einem Drucksensor (3) und ein Ausgangssignal des Drucksensors die aktuell bestimmte Regelgrösse (12) bereitstellt, und/oder
• mit einem Massenströmungsmesser (2) oder einer Massenströmungskontrolleinheit (2) und ein Ausgangssignal des Massenströmungsmesser bzw. der Massenströmungskontrolleinheit die aktuell bestimmte Regelgrösse (12) bereitstellt.

14. Verfahren zur Überprüfung eines geregelten Betriebs eines Vakuumventils (10), wobei das Vakuumventil (10) zur Regelung eines Volumen- oder Massenstroms und zum gasdichten Abschluss eines Prozessvolumens (1) ausgebildet ist und aufweist
• einen Ventilsitz, der eine eine Öffnungsachse (34) definierende Ventilöffnung (33) und eine die Ventilöffnung (33) umlaufende erste Dichtfläche (35) aufweist,
• einen Ventilverschluss (38) zum im Wesentlichen gasdichten Verschliessen der Ventilöffnung (33) mit einer zweiten zu der ersten Dichtfläche korrespondierenden Dichtfläche, und
• eine mit dem Ventilverschluss (38) gekoppelte Antriebseinheit (40), die derart ausgebildet ist, dass der Ventilverschluss (38)
□ zur Bereitstellung von jeweiligen Ventilöffnungszuständen, die von jeweiligen Zuständen des Ventilverschlusses (38) abhängen, definiert variierbar und einstellbar ist und
□ von einer Offenposition (O), in welcher der Ventilverschluss (38) die Ventilöffnung (33) zumindest teilweise freigibt in eine Schliessposition, in welcher die erste Dichtfläche auf die zweite Dichtfläche angedrückt ist und die Ventilöffnung (33) im Wesentlichen gasdicht verschliesst, und zurück verstellbar ist,
und wobei ein Regelprozesses durch Ansteuerung der Antriebseinheit basierend auf einer aktuell bestimmten Regelgrösse (12) für einen Prozessparameter und einer Zielgrösse (13) ausgeführt wird, wobei eine gezielte Variation bzw. Einstellung des Ventilöffnungszustands bereitgestellt ist, insbesondere wodurch die Regelgrösse an die Zielgrösse durch eine so bewirkte Zustandsänderung des Ventilverschlusses angenähert wird,
**dadurch gekennzeichnet, dass**
• im Rahmen der Ausführung des Regelprozesses eine Serie von Zuständen des Ventilverschlusses (38) über zumindest einen Zeitabschnitt des Regelprozesses erfasst wird und als aktuelle Regeldaten (21a) gespeichert wird,
• die aktuellen Regeldaten (21a) mit bestimmten Sollregeldaten (20,20a) verglichen werden und
• basierend auf dem Vergleich der aktuellen Regeldaten (21a) mit den bestimmten Sollregeldaten (20,20a) eine Prozessinformation erzeugt wird.

15. Computerprogrammprodukt, das auf einem maschinenlesbaren Träger gespeichert ist, insbesondere in einer Speichereinheit eines Ventilsystems nach einem der Ansprüche 1 bis 13, mit Programmcode zur Durchführung bzw. Steuerung zumindest der folgenden Schritte des Verfahrens nach Anspruch 14
• Ausführen eines Regelprozesses,
• Erfassen der Serie von Zuständen des Ventilverschlusses (38),
• Vergleichen der aktuellen Regeldaten (21a) mit den Sollregeldaten (20,20a) und
• Erzeugen der Prozessinformation,
insbesondere wobei das Programm in einer elektronischen Datenverarbeitungseinheit, insbesondere der Regeleinheit, eines Ventilsystems nach einem der Ansprüche 1 bis 13 ausgeführt wird.
